# EUROPEAN PATENT APPLICATION

(11) **EP 3 144 689 A2**
(43) Date of publication of application: **22.03.2017**
(21) Application number: 16189333.4
(22) Date of filing: 16.09.2016
(51) Int. Cl.: G01R 31/319, G06T 7/00

(54) **ELECTRICAL ISOLATION FOR A CAMERA IN A TEST AND MEASUREMENT TOOL**

(30) Priority: 16.09.2015 US 201562219415 P
(71) Applicant: FLUKE CORPORATION, Everett Washington 98203 (US)
(72) Inventor: RINGSRUD, Paul, Langley, WA 98260 (US); HUBER, Clark, Everett, WA 98203 (US)
(74) Representative: Clarke, Jeffrey David

(57) **Abstract**

Analysis systems can include both a test and measurement tool for generating measurement data representative of at least one parameter of a device under test and an imaging tool for generating image data representative of a target scene. A processor in communication with the test and measurement circuit and the imaging tool can process measurement data and image data. Isolation circuitry can be configured to provide isolation between the imaging tool and the test and measurement circuit while permitting communication between the processor and each of the test and measurement tool and the imaging tool. A display for presenting measurement data and/or image data can be electrically isolated from the test and measurement tool.

## Description

### CROSS-REFERENCES

This application claims the benefit of U.S. Provisional Application No. 62/219,415, filed September 16, 2015, the content of which is hereby incorporated by reference in its entirety.

### TECHNICAL FIELD

This disclosure generally relates to electrical test tools capable of withstanding high voltages and associated imaging tools.

### BACKGROUND

Various information regarding parameters of system components may be useful in analyzing individual component's performance, operating conditions, lifespan, and other various aspects. Some such information includes measureable quantities, such as a current, voltage, power, impedance, vibration, and the like. Analysis of components of a system may provide insight into ways the system may be improved, for example, by repairing or replacing faulty or otherwise non-optimal components. Various test and measurement tools are capable of performing such measurements, and are often used in analyzing such components.

In some instances, when analyzing electrical equipment, dangerously high voltages may at times be present in various parts of the circuit in the analysis instrument. Standards and practices exist to protect users from being exposed to these voltages, such as solid insulation between any potentially high voltage portions and the user.

In some examples, additional information may be helpful in analyzing such components. For example, imaging techniques, such as infrared imaging, may provide useful additional information. Infrared imagery of a system or components thereof can provide thermal patterns of the scene, highlighting temperature abnormalities in system components. Such imagery may be useful in diagnosing similar or different issues that may be detected or otherwise analyzed using standard test and measurement tools as discussed above.

Since the advent of thermal imaging applications in electrical environments, there has been a need to keep the operator at a safe distance from the electrical circuits under observation. In some situations, companies have developed optical windows for switch gear cabinets, enabling physical isolation from the high voltage, but allowing optical measurements.

In the event that a user is performing both imaging and other analysis (e.g., electrical measurement analysis), instances may occur in which the imaging apparatus is exposed to or proximate potentially high voltage environments. Thus, additional safety measures may be necessary for protecting the user from exposure to potentially dangerous signals via the imaging apparatus.

### SUMMARY

Aspects of this disclosure are directed toward systems and methods for providing combined test and measurement analysis and imaging analysis while providing adequate safety to a user. Embodiments in this disclosure include systems comprising a test and measurement tool comprising a test and measurement circuit and being configured to generate measurement data representative of at least one parameter of an object under test. A system can further include an imaging tool configured to generate image data representative of a target scene. In various embodiments, the imaging tool can include an infrared (IR) imaging tool and/or a visible light (VL) imaging tool.

Systems can include a processor in communication with the test and measurement tool and the imaging tool. The processor can be configured to receive and process measurement data and image data, such as for presentation on a display. Systems can include isolation circuitry configured to provide isolation between the imaging tool and the test and measurement circuit of the test and measurement tool. The isolation circuitry can permit communication between the processor and each of the test and measurement tool and the imaging tool. Thus, during operation, even if dangerous high voltages are present at the test and measurement circuit in the test and measurement tool, the imaging tool is electrically isolated from the test and measurement circuit and does not present a shock risk to the operator.

In various embodiments, the test and measurement tool and the imaging tool can be combined into a combination tool. In some such combination tools, imaging tools can be removably or fixedly attached to the test and measurement tool. One or more power supplies can provide electrical power to the test and measurement circuit, the imaging tool, and the processor. In some embodiments, a transformer can be present between the power supply and the test and measurement circuit to maintain electrical isolation between the test and measurement circuit and other components. Similarly, in some embodiments, an isolating communication channel can be configured to provide communication between the test and measurement circuit and the processor.

In some examples, the test and measurement circuit is physically separated from one or more other components, for example, to prevent or minimize the risk of arcing between the test and measurement circuit and such components. In some embodiments, the test and measurement circuit is positioned at least a predetermined distance from each of a power supply, a processor, and an imaging tool. The predetermined distance can be such that the distance meets IEC 61010 standards. For example, in some embodiments, the predetermined distance can be the minimum distance required by IEC 61010 based on a maximum voltage rating of the test and measurement circuit.

The details of one or more examples are set forth in the accompanying drawings and the description below. Other features, objects, and advantages will be apparent from the description and drawings, and from the claims.

### BRIEF DESCRIPTION OF DRAWINGS

FIGS. 1A and 1B provide front and back views of an exemplary system including a test and measurement tool and an imaging tool.
FIG. 2 is an exemplary schematic diagram of a test and measurement tool comprising a variety of components.
FIG. 3 shows an example block diagram of an imaging tool configured for receiving electromagnetic radiation according to some exemplary systems.
FIG. 4 is an exemplary schematic system diagram showing electrical isolation in a test and measurement tool communicating with an imaging tool.

### DETAILED DESCRIPTION

Aspects of the disclosure generally relate to systems and methods providing electrical isolation between portions of imaging tools and test and measurement tools, in some instances, when the imaging tool(s) and test and measurement tool(s) are integrated into a single combination tool. Test and measurement tools can be generally capable of determining at least one parameter of a device under test. Exemplary test and measurement tools can include, but are not limited to, digital multimeters, current measurement tools, power quality tools, vibration tools, portable oscilloscope tools, laser alignment tools, ultrasonic test tools, insulation resistance testers, multi-function electrical test tools, single-function electrical test tools, contact temperature measurement tools, humidity measurement tools, air-flow measurement tools, air temperature measurement tools, air quality and particulate measurement tools, and the like. In some embodiments, one or more such test and measurement tools can produce and/or measure an electrical signal that is unsafe for the operator of the test and measurement tool without proper protection.

One or more imaging devices can be integrated with or otherwise attached or attachable to a test and measurement tool such as described in U.S. Patent Application No. 14/855,884 entitled "TEST AND MEASUREMENT SYSTEM WITH REMOVABLE IMAGING TOOL," now published as U.S. Patent Publication No. 2016/0080666, or U.S. Patent Application No. 14,855/844 entitled "METHOD OF ATTACHING CAMERA OR IMAGING SENSOR TO TEST AND MEASUREMENT TOOLS," now published as U.S. Patent Publication No. 2016/0076936, each of which was filed September 16, 2015, is assigned to the assignee of the instant application and is hereby incorporated by reference in its entirety. In various examples, the imaging tool interfacing with a test and measurement tool can be sensitive to any of a variety of wavelengths. Exemplary imaging components can include sensors which can detect visible, near infrared (NIR), short-wavelength infrared (SWIR), long wavelength infrared (LWIR), terahertz (THz), ultraviolet (UV), X-Ray or other wavelengths. In some embodiments, the imaging component can include one or more imaging sensors, for example, infrared (IR) and visible light (VL) cameras.

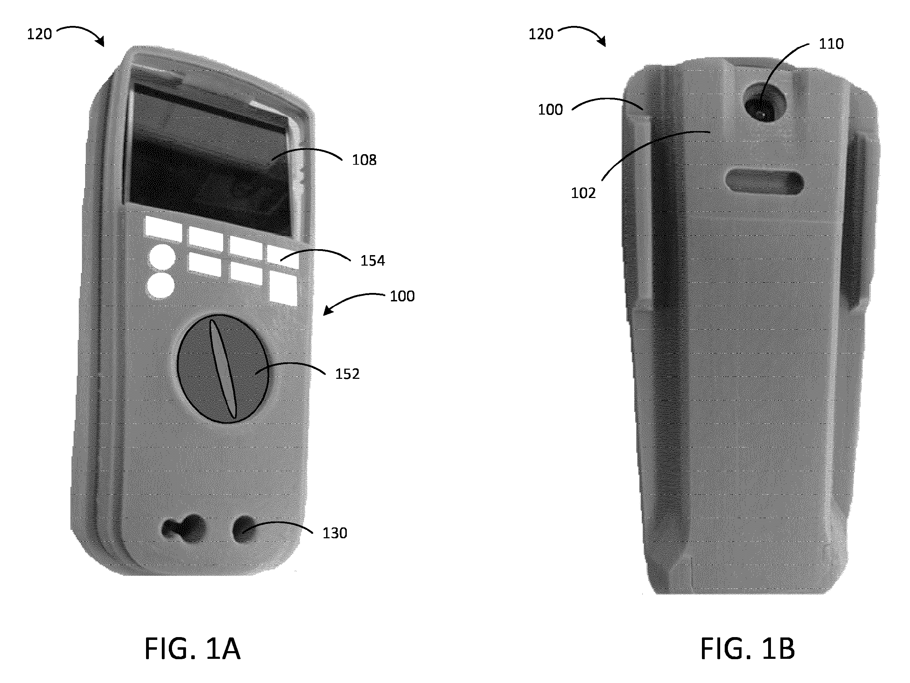

FIGS. 1A and 1B provide front and back views of an exemplary system including a test and measurement tool and an imaging tool. The embodiment of FIGS. 1A and 1B includes a test and measurement tool 100 and an imaging tool 110 combined into a single combination tool 120. In the illustrated embodiment, test and measurement tool 100 includes a back surface 102 through which the imaging tool 110 receives radiation from a target scene.

In some examples, imaging tool 110 can include a plurality of sensing components. For example, imaging tool 110 may include one or both of an infrared (IR) camera and a visible light (VL) camera. It will be appreciated that various imaging tools such as 110 can include any combination of appropriate sensors capable of detecting a variety of wavelengths.

In the example of FIGS. 1A and 1B, imaging tool 110 is integrated into test and measurement tool 100. That is, the system of FIG. 1 shows a combination tool 120 having integral test and measurement tool 100 and imaging tool 110. Imaging tool 110 includes a camera capable of detecting radiation in one or more ranges of wavelengths. As described, imaging tool 110 may include a plurality of cameras for detecting radiation in different wavelength spectrums. In some examples, the imaging tool may include a plurality of sensor arrays, each sensor array sensitive to a different range of wavelengths. Some such embodiments include optics for separating light incident to imaging tool and substantially directing light within certain wavelength ranges to corresponding sensor arrays.

The combination tool 120 of FIGS. 1A and 1B may be configured to generate image data and measurement data substantially simultaneously. In some examples, combination tool 120 includes a display 108 capable of presenting one or more of image data, measurement data, or other information. Additionally or alternatively, any one or more of the test and measurement tool 100, imaging tool 110, and combination tool 120 can communicate one or more of measurement data, image data, or combined measurement and image data to any other system component. In some examples, such data may be communicated to an external device, as described in U.S. Patent Application No. 14/855,989, filed September 16, 2015, entitled "DISPLAY OF IMAGES FROM AN IMAGING TOOL EMBEDDED OR ATTACHED TO A TEST AND MEASUREMENT TOOL," now published as U.S. Patent Publication No. 2016/0076937, which is assigned to the assignee of the instant application, and which is hereby incorporated by reference in its entirety.

In the front view of FIG. 1A, the tool 120 includes inputs 130, for example, for receiving one or more accessories (e.g., test leads). The one or more accessories can be used for interfacing with an object under test for generating measurement data representative of at least one parameter of a device under test. In some embodiments, test and measurement tool 100 in combination tool 120 may perform a plurality of different measurement functions via inputs 130. In some embodiments, the measurement function is selectable, for example, via a user interface 150. Interface 150 can include one or more elements by which a user can interact with the tool 120, such as a selection knob 152 or buttons 154, or other interface elements such as a touchscreen, switches, and the like.

Combination tool 120 includes a display 108. Display 108 can be used to present various information to the user. In some examples, display 108 can be configured to present measurement data generated by the test and measurement tool 100. Additionally or alternatively, the display 108 can be configured to present image data generated by imaging tool 110. In some embodiments, a combination of measurement data and image data can be presented on the display 108 for presentation to a user.

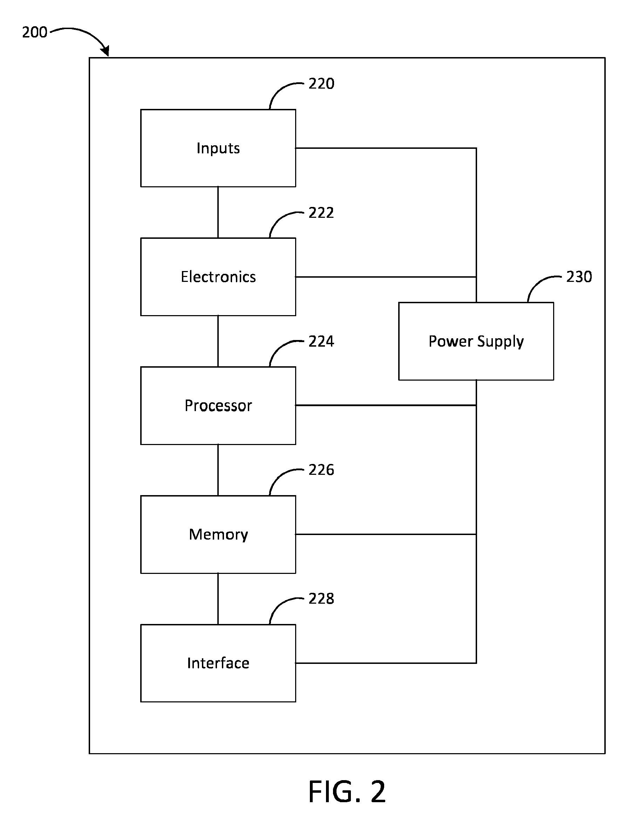

FIG. 2 is an exemplary schematic diagram of a test and measurement tool comprising a variety of components. In the illustrated example, the test and measurement tool 200 may include one or power supplies 230 for providing electrical power to any of a variety of system components for performing a variety of tasks, such a performing one or more primary functions. In some embodiments, the one or more power supplies 230 may include one or more batteries. Additionally or alternatively, the test and measurement tool 200 may be capable of running on AC power, e.g., from a standard wall receptacle. In some such embodiments, one or more batteries of the test and measurement tool 200 may be charged while the tool 200 is operating on or otherwise plugged into an AC power source.

The test and measurement tool may include one or more inputs 220 configured to interface with an object under test for performing a measurement of a parameter thereof. In various examples, the one or more inputs 220 may include any appropriate input for performing a measurement of a parameter of a device under test. The one or more inputs 220 may provide a signal indicative the parameter of the object under test to any combination of electronics 222 and a processor 224 for further processing of the signal. In some examples, the test and measurement tool 200 includes a memory 226 for storing information indicative of one or more parameters of a device under test. In some embodiments, one or both of processor 224 and memory 226 may be integrated into electronics 222.

In some embodiments, test and measurement tool 200 may include an interface 228 for interacting with a user. In some examples, interface 228 may include one or more controls for receiving user inputs. Controls may include, for example, buttons, switches, knobs, touch screens, etc. In some embodiments, a user may initiate a measurement or other test and measurement tool 200 function using controls. Additionally or alternatively, the interface may include a display for communicating information to a user. For example, the display may present a user with selectable options, such as various functions selectable by the user via controls. Additionally or alternatively, the display may be configured to present the results of one or more measurements performed by the test and measurement tool for observation by a user. In some examples, a display is capable of presenting textual measurement information (e.g., letters, numbers, etc.), but is not capable of displaying image information, such as described elsewhere herein. Additionally or alternatively, in some embodiments, power supply 230 is not capable of supporting a continuous image display without severely depleting the available power supply. Thus, in some examples, presentation of image data via interface 228 may be impossible or impractical.

In some examples, interface 228 may provide an interface with additional equipment. For example, in some embodiments, interface 228 can provide a communication interface between the test and measurement tool 200 and an imaging tool (e.g., 110) or an external device (e.g., smartphone, tablet, etc.). In various embodiments, interface 228 can be used to export received measurement data, such as from inputs 220, or a processed result, for example, from processor 224.

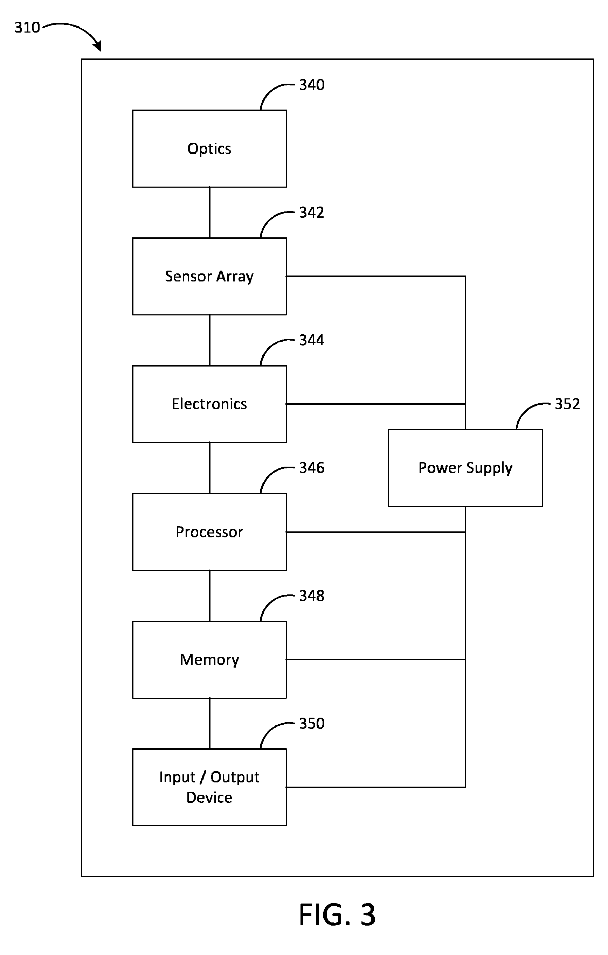

FIG. 3 shows an example block diagram of an imaging tool configured for receiving electromagnetic radiation according to some exemplary systems. In the illustrated embodiment, imaging tool 310 includes optics 340, a sensor array 342, electronics 344, one or more processors 346, memory units 348, input/output devices 350, and a power supply 352.

The optics 340 can include optics for focusing, deflecting, and/or reflecting electromagnetic radiation from a target object onto the sensor array 342. In some examples, the sensor array 342 may include an infrared sensor array sensitive to infrared radiation. An imaging tool including such an infrared sensor array may be used to make non-contact temperature measurements.

In such embodiments, the infrared sensor array 342 can include one or more thermal detectors such as microbolometers or thermopiles, or could be composed of photon detectors such as photodiodes or phototransistors, or other thermal or photon detection device. In some examples, an infrared sensor array may include a single detector, for instance, for determining a spot temperature within a target scene. Alternatively, an infrared sensor array may comprise a plurality of such detectors for acquiring at least one of a spot temperature (e.g., via an average value of sensor array sensors) and a two-dimensional infrared image.

One having ordinary skill in the art will recognize that various sensor arrays (e.g. photon sensor arrays) can be used, and can be used in combination with one or more infrared sensor arrays. In some examples, the sensor array is fixed within the imaging tool 310 to provide a more durable device having fewer moving and moveable parts. In various examples, the size and positioning of the detector depends on the characteristics of the optical system (e.g., the relationship between optics 340 and sensor array 342). In some embodiments, the detector is generally circular having a diameter of 0.5 mm to 3 mm. However detectors of any size and shape should be considered within the scope of the invention. The detector produces a signal as a function of the radiation or other scene data imaged thereupon. These signals can be processed by known methods to indicate a temperature or other metric indicated via the received radiation.

A person having ordinary skill in the art will recognize that many materials and materials technologies may be suitable for use in an infrared sensor array. In some examples, the infrared sensor array 342 responds to infrared radiation ranging from approximately 0.7 microns to approximately 30 microns and can have a peak sensitivity within this range. The electronics 344 receive the output signals from the sensor array 342 and pass them to the processor 346 for analysis.

When an infrared sensor assembly is used, the processor 346 can be used to run infrared thermometer applications including, but not limited to, deciding if the target object sufficiently fills the field of view, and averaging output signals for a period of time to reduce the impact of noisy measurements on the accuracy of the measured temperature. In the case of alternative sensor arrays (e.g., sensitive to one or more of visible light, ultraviolet light, X-rays, etc.), the processor 346 may be used to run corresponding imaging applications.

Memory 348 can include but is not limited to, RAM, ROM, and any combination of volatile and non-volatile memory. A power supply 352 can include, but is not limited to, a battery, a parasitic energy system (e.g., an inductive system), and components for directly receiving AC power. The power supply 352 can provide power to the sensor array 342, electronics 344, processor 346, memory 348, and/or input/output devices 350. An input/output device 350 can include, but is not limited to, triggers to start and stop the image capture, visual displays, speakers, and communication devices that operate through wired or wireless communications.

For instance, in some examples, the input/output device 350 of the imaging tool 310 can include a display capable of displaying an image produced from data conveyed or captured by one or more sensor arrays 342. In some examples, the display can be further configured to show other data, for instance, data from the test and measurement tool (e.g., via a communication port (not shown)) or other external sources. Additionally or alternatively, input/output device 350 may be capable of one or more of receiving measurement data from a measurement tool and communicating at least one of image data and received measurement data to an external device, such as a tablet, smartphone, computer, etc.

In some embodiments, the functionality of one or more components of one or both of the test and measurement tool 200 or imaging tool 310 can be shared between the components. For example, in some embodiments, a combination tool comprising a test and measurement tool and an imaging tool can include a processor capable of performing the processing functions of processor 224 and processor 346. Additionally or alternatively, a single memory in a combination tool can be capable of performing the functions of memory 226 and memory 348. Similarly, such a combination tool can include a single power supply, interface, or the like. In general, combination tools having both a test and measurement tool and an imaging tool can share any of a variety of components configured to interface with both the test and measurement tool and the imaging too.

As described elsewhere herein, in some examples, an imaging tool can be removably attached to a test and measurement tool to form a combination tool. In some such examples, one or both of the imaging tool and the test and measurement tool can include various components, such as a processor, memory, interface, display, and the like. Wired and/or wireless communication between the imaging tool and test and measurement tool can be used to communicate measurement data and/or image data between the tools. Several such configurations are described in U.S. Patent Application No. 14/855,884, entitled "TEST AND MEASUREMENT SYSTEM WITH REMOVABLE IMAGING TOOL," now published as U.S. Patent Publication No. 2016/0080666, which is incorporated by reference. Similarly, one or both of imaging tool and test and measurement tool can be in communication with an external device. The external device may include components such as memory, a processor, and/or a display. In various embodiments, such components can be used in addition to similar components in the test and measurement tool and/or the imaging tool, or can replace the functionality of such components. For instance, in some examples, image data and/or measurement data can be communicated to an external device for processing and/or display. Some such configurations are described in U.S. Patent Application No. 14/855,989, filed September 16, 2015, and entitled "DISPLAY OF IMAGES FROM AN IMAGING TOOL EMBEDDED OR ATTACHED TO A TEST AND MEASUREMENT TOOL," now published as U.S. Patent Publication No. 2016/0076937, which is incorporated by reference.

In some embodiments, a test and measurement tool may be capable of measuring high voltages. Accordingly, in some instances, such high voltages (or other potentially dangerous and/or damaging signals) may at times be present within circuitry (e.g., electronics 222) of the test and measurement tool. Standards and practices exist to protect users of typical test and measurement tools from being exposed to such high voltages. For example, one or both of solid state insulation and sufficient spacing between potentially high voltage portions of a test and measurement tool and location physically accessible to a user may provide protective electrical isolation to an operator.

For example, IEC 61010 standard for CAT III 1000V rated products requires approximately 16 millimeters spacing from components on which at high voltage could be present. Similarly, IEC 61010 can require different spacing for different voltage ratings. For instance, CAT IV 600V rated products can require approximately 14.3 millimeters spacing between components. In some examples, the amount of spacing required can be reduced when solid materials (e.g., electrically insulating materials) are disposed between the potentially high voltage components and a user, such as an insulating casing of a test tool. In some examples, an electrically insulating casing of a test tool provides sufficient insulation between a user and potentially high voltage components internal to the test tool. In some embodiments, seams in the insulating casing are positioned that, when tracing a path through the seams, the path length from the outer surface of the casing to any potentially high voltage component meets the required distance standard.

However, when an imaging tool is incorporated (e.g., built-in, removably attached, etc.) into a test and measurement tool capable of performing such high-voltage measurements, the imaging tool may provide a weak point in the protective insulating properties of the test and measurement tool. For example, insulating casings used in test tools are often too opaque to allow radiation of desired wavelengths to pass therethrough. Accordingly, in some such embodiments, the imaging tool at least cannot be fully surrounded by such an insulating material. Thus, an imaging tool that is in close proximity with or in communication with a potentially high voltage portion of a test and measurement tool, or is in communication with a common component (e.g., a processor, memory, etc.), may include components at dangerously high voltages.

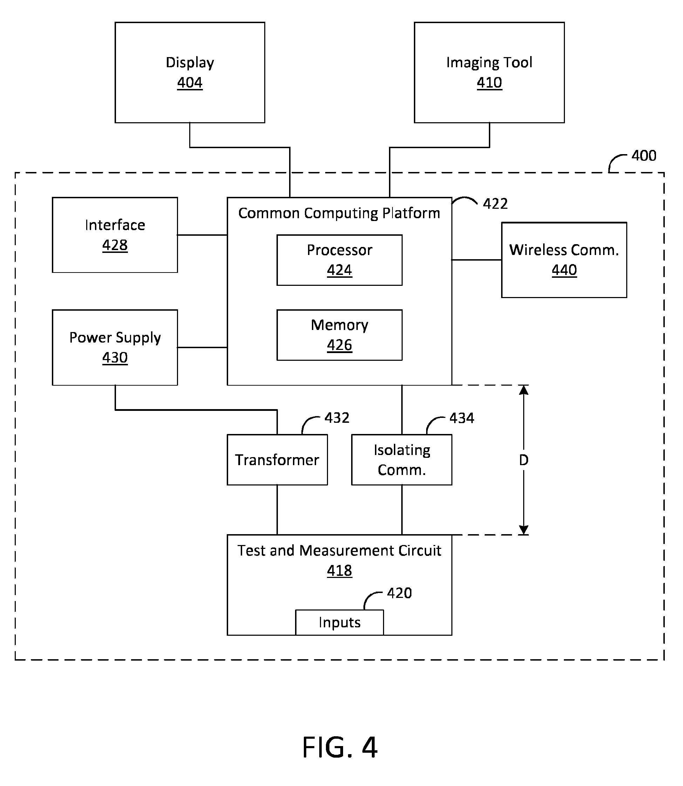

FIG. 4 is an exemplary schematic system diagram showing electrical isolation in a test and measurement tool communicating with an imaging tool. In the illustrated embodiment, the test and measurement tool 400 includes a test and measurement circuit 418 including inputs 420 for interfacing with a device under test. Inputs 420 may effectively couple the device under test with the test and measurement circuit 418. For example, inputs 420 may receive test leads attached to a piece of high-voltage equipment. In some examples, the test and measurement circuit 418 may be capable of receiving the voltage from the inputs 420 and generate a signal representative of the voltage across a portion of the high-voltage equipment.

In the illustrated example, the test and measurement circuit 418 is in communication with a common computing platform 422 via an isolating communication channel 434. The common computing platform 422 can include a processor 424 and memory 426. In some examples, memory 426 includes instructions for causing the processor 424 to execute various tasks. For instance, in an exemplary configuration, the memory 426 can include instructions to processor 424 for receiving and processing data from the test and measurement circuit 418.

The common computing platform 422 of FIG. 4 is further in communication with an imaging tool 410. In such embodiments, the imaging tool 410 can be capable of communicating received image data to the common computing platform 422. The memory 426 of the common computing platform 422 can include instructions for processing received image data via the processor 424. In some examples, imaging tool 410 can be similar to any one or more or the exemplary imaging tools shown or described in FIGS. 3-8 of U.S. Patent Application No. 14,855/844, entitled "METHOD OF ATTACHING CAMERA OR IMAGING SENSOR TO TEST AND MEASUREMENT TOOLS," now published as U.S. Patent Publication No. 2016/0076936, which is incorporated by reference, though it will be appreciated that other imaging tool configurations are possible.

The system shown in FIG. 4 includes a display 404 in communication with the common computing platform 422. The display 404 can be capable of presenting one or both of image data and measurement data. For example, the common computing platform 422 can be configured to process received image data for presentation on the display 404. Similarly, the common computing platform 422 can be configured to process received measurement data for presentation on the display 404. In some examples, the common computing platform 422 can receive image data from the imaging tool 410 and measurement data from the test and measurement circuit 418 substantially simultaneously. In some such examples, the processor 424 can combine the received measurement data and image data for presentation of the combined data to a user via the display 404.

As shown, the test and measurement tool 400 can include an interface 428 capable of interfacing with a user. In some examples, a user may initiate one or more tasks to be carried out by the test and measurement tool 400 via the interface 428, such as acquiring measurement data using the test and measurement circuit 418. In the event of an imaging tool 410 in communication with the test and measurement tool 100, a user may additionally or alternatively initiate the capturing of image data via imaging tool 410 via interface 428. In various examples, a user may select a variety of options via the interface 428, such as a type of measurement data to acquire, which information to present on the display 404, how information is presented (e.g., image data palettization schemes, etc.), and the like. The interface 428 can include, for example, one or more buttons, knobs, touchscreens, or any other appropriate interface.

The illustrated test and measurement tool 400 includes a power supply 430 configured to provide electrical power to one or more system components. In the illustrated embodiment, the power supply 430 provides electrical power to operate the common computing platform 422. Power supply 430 is also configured to power the test and measurement circuit 418 via a transformer 432. Power supply 430 may include one or more batteries or other portable charge storage device. In some embodiments, power supply 430 may include an AC power source, such as a plug for receiving AC power from a standard wall receptacle. Additionally or alternatively to providing power to the common computing platform 422 and the test and measurement circuit 418, in some embodiments, power supply 430 may provide electrical power to one or both of the imaging tool 410 and display 404.

As discussed elsewhere herein, electrically isolating portions of the test and measurement circuit 418 from the user may provide desired or even required safety for the user. In the illustrated embodiment, isolating communication channel 434 enables communication between the test and measurement circuit 418 and the common computing platform 422 without providing an electrically conductive path therebetween. Exemplary isolating communication channels 434 may be capable of two-way communication and can include any one or more of optical isolators, wireless communication devices (e.g., RF, Bluetooth, etc.), magnetic communication components, and/or other known isolating communication components. Similarly, in the illustrated embodiment, transformer 432 provides electrical power to the test and measurement circuit 418 from the power supply 430 without providing an electrically conductive path therebetween.

In some examples, transformer 432 provides galvanic isolation between the test and measurement circuit 418 and other portions of the test and measurement tool 400. In some embodiments, the transformer is designed to meet requirements of IEC 61010 for 1000V CAT III isolation. Accordingly, the test and measurement circuit 418 may receive electrical power from the power supply of the test and measurement tool 400 and communicate with the common computing platform 422 while remaining electrically isolated from such components. Such isolation can provide the necessary isolation between possible high-voltage components connected to the test and measurement circuit 418 via inputs 420 and a user operating the test and measurement tool 400.

As shown in the embodiment of FIG. 4, a distance D separates the test and measurement circuit 418 from other electrical components that are electrically isolated therefrom, such as the common computing platform 422. The physical separation (D) between the test and measurement circuit 418, which may be electrically coupled to, for example, a high voltage object under test via inputs 420, can provide a measure of electrical isolation between such components. For example, inadequate physical separation between a high voltage element in the test and measurement circuit 418 and a component electrically isolated therefrom, such as the common computing platform 422, may lead to arcing between such components despite the electrical isolation therebetween. Arcing can pose a risk to the user and the equipment. Adequate physical separation between the test and measurement circuit 418 and other components may reduce the risk of arcing.

The distance D for reducing the risk of arcing may depend on the maximum voltage (or other signal) intended for measurement by the test and measurement circuit. For example, in some embodiments, for 1000V CAT III isolation, the distance, D, may be approximately 16 millimeters or greater to prevent arcing. In some examples, a minimum value for the distance D is dictated by safety standards. For instance, in some embodiments, the distance D is based on the IEC 61010 safety standards. In some such examples, the actual distance D can be dependent on the voltage rating of the tool combined with the IEC 61010 standard. In some examples, a minimum distance D for meeting one or more safety requirements can depend on materials between the high and low voltage areas. For instance, a solid insulator between the common computing platform 422 and the test and measurement circuit 418 may reduce the minimum distance D therebetween required to meet certain safety standards.

The electrical isolation between the test and measurement circuit 418 and the common computing platform 422 allows the imaging tool 410 to communicate directly with the common computing platform 422 while remaining isolated from the test and measurement circuit 418. The imaging tool 410, being electrically isolated from the test and measurement circuit 418 (even if the imaging tool 410 and test and measurement tool 400 are integrated into a combination tool), can communicate with the common computing platform 422 via any known methods without exposing a user to a potentially dangerous high voltage or other signal. Accordingly, there are no limitations (e.g., resolution, image data size, image framerate, etc.) placed on the communication between the imaging tool 410 and the common computing platform 422 due to the risk of dangerous signals in the test and measurement circuit 418.

The system of FIG. 4 shows an exemplary arrangement of a variety of components. It will be appreciated that several alternative configurations are possible. For example, while shown as being within the test and measurement tool 400 in the embodiment of FIG. 4, it will be appreciated that the common computing platform 422 may be external to the test and measurement tool 400. For example, common computing platform 422 or portions thereof may be located within the imaging tool 410 or in an external device in communication with one or both of the test and measurement tool 400 and the imaging tool 410, such as a smartphone, tablet, computer, and the like. Communication between the common computing platform 422 and various components, such as the imaging tool 410 or the isolating communication channel 434 may be provided by one or both of wired or wireless communication channels.

As described elsewhere herein, the imaging tool 410 may be separate, separable, or integrated into the test and measurement tool 400. Additionally or alternatively, while shown separately from the test and measurement tool 400 and imaging tool 410, the display may be integrated into test and measurement tool 400, the imaging tool 410, a combination tool, or may be a standalone component in wired or wireless communication with the common computing platform 422.

In some examples, various electrical isolation components may be positioned elsewhere in the system. For instance, in some embodiments, the common computing platform 422 may be in electrical communication with the test and measurement circuit 418. Isolating components (e.g., transformer 432, isolating communication channel 434, etc.) may be used to provide communication between the imaging tool 410 and the common computing platform 422 so that the imaging tool remains electrically isolated from any potential high voltages present at the test and measurement circuit 418. In some examples, isolation between a potentially high-voltage area and other system components may be selected so that the lowest data rate and lowest power consumption portions of the circuitry are isolated.

In some embodiments, power supply 430 may be used to provide electrical power to any variety of system components. For examples, in a combination tool having integrated imaging tool 410, test and measurement tool 400, and display 404, power supply 430 may provide electrical power for each component. Isolating components such as transformer 432 may be used to maintain electrical isolation between, for example, the test and measurement circuit 418 and other system components while still using a common power supply 430. In other embodiments, one or more system components (e.g., display 404, imaging tool 410, test and measurement circuit 418, etc.) may include its own dedicated power supply, such as one or more batteries or other portable charge storage technology.

In some embodiments, the display 404 may be located in any one or more of imaging tool 410, test and measurement tool 400, and in an external device, such as a smartphone, tablet, computer, etc. In some examples, display 404 may be a standalone display in communication with the imaging tool 410 and test and measurement tool 400 for receiving image data and measurement data therefrom, respectively. In some examples, a system (e.g., the test and measurement tool 400, imaging tool 410, or other component) may include a wireless communication link 440 for communicating data to the display 404 (e.g., a standalone display or in an external device).

In various embodiments, the wireless communication link 440 can be used for communicating data to or receiving data from any one or more of other imaging and/or test and measurement tools (e.g., tool-to-tool communication), external devices (e.g., smartphones, tablets, computers, etc.), audio devices, or other appropriate devices. Various wireless communication methods can be possible, such as Zigbee communication, for example, for tool-to-tool communication), or WiFi communication. WiFi communication can provide communication with external device such as phone, tablet, computer, etc. or a local area network (LAN) hub which can communicate with cloud-based communication nodes or serves, such as described, for example, in U.S. Patent Publication No. 20140278259, corresponding to U.S. Patent Application No. 14/214,600, filed March 14, 2014, and entitled "CAPTURE AND ASSOCIATION OF MEASUREMENT DATA," and U.S. Patent Publication No. 20140270546, corresponding to U.S. Patent Application No. 14/214,624, filed March 14, 2014, and entitled "UNIFIED DATA COLLECTION AND REPORTING INTERFACE FOR EQUIPMENT," each of which is assigned to the assignee of the instant application, and is hereby incorporated by reference in its entirety.

In general, as discussed, a processor, such as processor 424 in the common computing platform 422, can be used to generate a display for presentation to a user based on received image and measurement data. Processed or unprocessed information may be communicated to the location of display 404, where the information can be presented to a user.

In some embodiments, electrical isolation between the imaging tool 410 and the test and measurement circuit 418 prevents the imaging tool 410 from developing a dangerously high voltage. That is, in some such examples, the imaging tool 410 does not provide a significant safety risk to a user even if the test and measurement circuit 418 is at a high voltage. Additional safety precautions such as those described in, for example, U.S. Provisional Application No. 62/219,415, which is incorporated herein by reference, and U.S. Patent Application No. 15/262,873, filed September 12, 2016, entitled "SYSTEMS AND METHODS FOR PLACING AN IMAGING TOOL IN A TEST AND MEASUREMENT TOOL," which is assigned to the assignee of the instant application, and is incorporated herein by reference in its entirety, can be used to protect the user of possible dangerous electrical signals from the test and measurement circuit from harming the user via the imaging tool. In fact, in some embodiments, imaging tool may protrude from the test and measurement tool.

An electrically isolated imaging tool such as 410 in FIG. 4 may be removably attached to the test and measurement tool 400, such as described, for example, in U.S. Patent Application No. 14/855,884, entitled "TEST AND MEASUREMENT SYSTEM WITH REMOVABLE IMAGING TOOL," now published as U.S. Patent Publication No. 2016/0080666, which is incorporated by reference. Additionally or alternatively, an isolated imaging tool may include a movable imaging element (e.g., a sensor array) as described in U.S. Patent Application No. 14,855/844, entitled "METHOD OF ATTACHING CAMERA OR IMAGING SENSOR TO TEST AND MEASUREMENT TOOLS," now published as U.S. Patent Publication No. 2016/0076936, which is incorporated by reference. In various embodiments, imaging tool 410 can be integrally embedded in test and measurement tool 400, removably attachable to the test and measurement tool 400, and/or protrude from the test and measurement tool. In general, electrical isolation between the imaging tool 410 and the test and measurement circuit 418 can protect the user of potentially dangerous signals (e.g., voltage) present in the test and measurement circuit 418.

Examples provide a system comprising a test and measurement tool comprising a test and measurement circuit, the test and measurement tool configured to generate measurement data representative of at least one parameter of an object under test, an imaging tool configured to generate image data representative of a target scene, a processor in communication with the test and measurement tool and the imaging tool and configured to receive and process measurement data and image data for display, isolation circuitry configured to provide galvanic isolation between the imaging tool and the test and measurement circuit of the test and measurement tool while permitting communication between the processor and each of the test and measurement tool and the imaging tool, a display in communication with the processor and capable of presenting a display based on the processed measurement data and image data.

In some examples, the test and measurement tool and imaging tool are combined into a single combination tool.

In some examples, the combination tool comprises a power supply configured to provide electrical power to the test and measurement circuit, the imaging tool, and the processor.

Some examples further comprise a transformer disposed between the power supply and the test and measurement circuit, and an isolating communication channel configured to provide communication between the test and measurement circuit and the processor while maintaining electrical isolation therebetween, whereby the test and measurement circuit is electrically isolated from the power supply, the processor, and the imaging tool via the transformer and the isolated communication channel.

In some examples, the isolating communication channel comprises an optical isolator.

In some examples, the test and measurement circuit is positioned at least predetermined distance from each of the power supply, the processor, and the imaging tool, and wherein the predetermined distance meets IEC 61010 standards.

In some examples, the imaging tool is removable from the combination tool.

In some examples, the display is in wireless communication with the processor, the test and measurement tool, and/or the imaging tool.

In some examples, the imaging tool comprises an infrared camera module configured to generate infrared image data representative of the target scene.

In some examples, the imaging tool further comprises a visible light camera module configured to generate visible light image data representative of the target scene.

Examples provide an analysis system comprising a high voltage portion, comprising one or more inputs configured to interface with a device under test and a test and measurement circuit configured to interface with the one or more inputs and to receive high voltage measurement data from the device under test via the one or more inputs, a low voltage portion electrically isolated from the high voltage portion, the low voltage portion comprising an imaging tool configured to generate image data representative of a target scene and a display device, an isolating communication interface configured to facilitate communication between the high voltage portion and the low voltage portion, and a processor in communication with the test and measurement circuit, the imaging tool, the display device, and the isolating communication interface, the processor being configured to generate display data for presentation on the display device, the display data including one or both of image data and measurement data.

In some examples, the processor is positioned in the low voltage portion and communicates with the test and measurement circuit via the isolating communication interface.

In some examples, the high voltage portion and the low voltage portion are supported by a single housing.

In some examples, all components located in the high voltage portion are separated from all components in the low voltage portion by at least a predetermined distance and/or an insulating material, wherein the predetermined distance meets IEC 61010 standards.

In some examples, the housing includes an insulating outer layer surrounding at least the high voltage portion.

In some examples, the imaging tool is removable from the housing.

In some examples, the low voltage portion further comprises a power supply, and wherein the system further comprises a transformer in communication with the power supply and configured to provide electrical power to the high voltage portion.

Some examples further comprise memory in communication with the processor, the memory being configured to store image data from the imaging tool and/or measurement data from the test and measurement circuit.

In some examples, the low voltage portion further comprises a user interface in communication with the processor.

Examples provide a combination tool comprising a test and measurement circuit comprising one or more inputs configured to interface with a device under test, an imaging tool electrically isolated from the test and measurement circuit and comprising at least one camera module configured to generate image data representative of a target scene, a processor in communication with the test and measurement circuit and the imaging tool, and a display electrically isolated from the test and measurement circuit and in communication with the processor, the display being configured to present a display based measurement data and/or image data received by the processor.

In some examples, the test and measurement circuit, the imaging tool, and the display are supported by a single housing.

Various examples have been described. These and other examples are within the scope of the following claims.

## Claims

1. A system comprising
a test and measurement tool comprising a test and measurement circuit, the test and measurement tool configured to generate measurement data representative of at least one parameter of an object under test;
an imaging tool configured to generate image data representative of a target scene;
a processor in communication with the test and measurement tool and the imaging tool and configured to receive and process measurement data and image data for display;
isolation circuitry configured to provide galvanic isolation between the imaging tool and the test and measurement circuit of the test and measurement tool while permitting communication between the processor and each of the test and measurement tool and the imaging tool;
a display in communication with the processor and capable of presenting a display based on the processed measurement data and image data.

2. The system of claim 1, wherein the test and measurement tool and imaging tool are combined into a single combination tool.

3. The system of claim 2, wherein the combination tool comprises a power supply configured to provide electrical power to the test and measurement circuit, the imaging tool, and the processor.

4. The system of claim 3, further comprising
a transformer disposed between the power supply and the test and measurement circuit; and
an isolating communication channel configured to provide communication between the test and measurement circuit and the processor while maintaining electrical isolation therebetween; whereby
the test and measurement circuit is electrically isolated from the power supply, the processor, and the imaging tool via the transformer and the isolated communication channel.

5. The system of claim 4, wherein the isolating communication channel comprises an optical isolator; and/or
wherein the test and measurement circuit is positioned at least a predetermined distance from each of the power supply, the processor, and the imaging tool, and wherein the predetermined distance meets IEC 61010 standards.

6. The system of any of claims 2 to 5, wherein the imaging tool is removable from the combination tool; and/or
wherein the display is in wireless communication with the processor, the test and measurement tool, and/or the imaging tool.

7. The system of any preceding claim, wherein the imaging tool comprises an infrared camera module configured to generate infrared image data representative of the target scene; and/or
wherein the imaging tool further comprises a visible light camera module configured to generate visible light image data representative of the target scene.

8. An analysis system comprising:
a high voltage portion comprising:
one or more inputs configured to interface with a device under test and
a test and measurement circuit configured to interface with the one or more inputs and to receive high voltage measurement data from the device under test via the one or more inputs;
a low voltage portion electrically isolated from the high voltage portion, the low voltage portion comprising:
an imaging tool configured to generate image data representative of a target scene; and
a display device;
an isolating communication interface configured to facilitate communication between the high voltage portion and the low voltage portion; and
a processor in communication with the test and measurement circuit, the imaging tool, the display device, and the isolating communication interface, the processor being configured to generate display data for presentation on the display device, the display data including one or both of image data and measurement data.

9. The analysis system of claim 8, wherein the processor is positioned in the low voltage portion and communicates with the test and measurement circuit via the isolating communication interface.

10. The analysis system of claims 8 or 9, wherein the high voltage portion and the low voltage portion are supported by a single housing; optionally
wherein all components located in the high voltage portion are separated from all components in the low voltage portion by at least a predetermined distance and/or an insulating material, wherein the predetermined distance meets IEC 61010 standards.

11. The analysis system of claim 10, wherein the housing includes an insulating outer layer surrounding at least the high voltage portion; and/or
wherein the imaging tool is removable from the housing.

12. The analysis system of any of claims 8 to 11, wherein the low voltage portion further comprises a power supply, and wherein the system further comprises a transformer in communication with the power supply and configured to provide electrical power to the high voltage portion.

13. The analysis system of any of claims 8 to 11, further comprising memory in communication with the processor, the memory being configured to store image data from the imaging tool and/or measurement data from the test and measurement circuit; and/or
wherein the low voltage portion further comprises a user interface in communication with the processor.

14. A combination tool comprising:
a test and measurement circuit comprising one or more inputs configured to interface with a device under test;
an imaging tool electrically isolated from the test and measurement circuit and comprising at least one camera module configured to generate image data representative of a target scene;
a processor in communication with the test and measurement circuit and the imaging tool; and
a display electrically isolated from the test and measurement circuit and in communication with the processor, the display being configured to present a display based measurement data and/or image data received by the processor.

15. The combination tool of claim 14, wherein the test and measurement circuit, the imaging tool, and the display are supported by a single housing.
